# EUROPÄISCHE PATENTSCHRIFT

(11) **EP 3 089 263 B1**
(45) Veröffentlichungstag und Bekanntmachung des Hinweises auf die Patenterteilung: **13.04.2022**
(21) Anmeldenummer: 15165568.5
(22) Anmeldetag: 29.04.2015
(51) Int. Cl.: H01Q 1/27

(54) **TRAGBARE RICHTANTENNE, MESSANORDNUNG UND MESSVERFAHREN**
PORTABLE DIRECTIONAL ANTENNA, MEASURING ASSEMBLY AND MEASURING METHOD
ANTENNE DIRECTIONNELLE PORTATIVE, DISPOSITIF DE MESURE ET PROCÉDÉ DE MESURE

(43) Veröffentlichungstag der Anmeldung: 02.11.2016
(73) Patentinhaber: Rohde & Schwarz GmbH & Co. KG, 81671 München (DE)
(72) Erfinder: Hisch, Martin, 85661 Forstinning (DE)
(74) Vertreter: Isarpatent

(56) Entgegenhaltungen:
- EP-A2- 2 696 213
- DE-A1-102010 051 213
- US-A- 4 199 246
- US-A- 5 886 672
- None

## Beschreibung

### GEBIET DER ERFINDUNG

Die vorliegende Erfindung betrifft eine tragbare Richtantenne. Die vorliegende Erfindung betrifft ferner eine tragbare Messanordnung sowie ein Verfahren zum Messen eines von einer Quelle ausgesendeten elektromagnetischen Signals.

### TECHNISCHER HINTERGRUND

Die vorliegende Erfindung bezieht sich auf das Detektieren von Funkstörungen. Unter einer Funkstörung - häufig auch als elektromagnetische Störung bezeichnet - ist die Auswirkung einer durch Aussendung, Ausstrahlung oder Induktion (oder durch deren Kombination) entstehende unerwünschte Energie bezeichnet, die sich negativ auf den Empfang in einem Funksystem auswirken können. Die vorliegende Erfindung sowie die ihr zugrundeliegende Problematik werden nachfolgend in Bezug auf Funkstörungen im Mobilfunkbereich erläutert, ohne jedoch die Erfindung darauf zu beschränken.

Ursachen für Funkstörungen im Mobilfunkbereich können defekte Antennen an einem Mobilfunkmast sein. Zur Ortung einer solchen Störquelle werden z.B. Richtantennen verwendet. Richtantennen sind Empfänger mit einer bauartbedingt verstärkten Richtempfangscharakteristik. Somit konzentriert eine Richtantenne als Empfangsantenne ihre maximale Empfangsempfindlichkeit in eine gewünschte Richtung mit einem je nach Anwendungsfall mehr oder weniger geringen Öffnungswinkel. Durch die Richtwirkung wird der Empfang von Signalen außerhalb der Hauptkeule des elektromagnetischen Signals gedämpft.

Eine derartige Richtantenne ist z.B. in der DE 10 2010 051 213 A1 beschrieben. Mit einer solchen Richtantenne lässt sich eine Störquelle erkennen und mittels eines eingebauten GPS-Sensors lässt sich die exakte GPS-Position bestimmen.

Allerdings kann bisweilen selbst bei einer mit einem GPS-Sensor ausgestatteten Richtantenne und damit selbst bei Kenntnis der GPS-Position die Störquelle im Nachhinein nicht aufgefunden werden, z.B. wenn mehrere Störquellen eng beieinander stehen, wie dies innerorts der Fall sein kann. Des Weiteren treten Funkstörungen auch innerhalb von Gebäuden auf, wo z.B. kein GPS-Empfang vorhanden ist.

Die EP 2 696 213 A2 bezieht sich auf eine Echtzeit RF-Signal-Visualisierungseinrichtung, die es ermöglicht, einen Benutzer bei der Identifizierung des Ortes einer RF-Quelle zu unterstützen. Antennenarrays, die mit entsprechenden Empfängern gekoppelt sind, liefern Signale zu einem Berechnungsblock, der dazu ausgelegt ist, eine Richtung der aufgenommenen bzw. empfangenen Information zu ermitteln. Die ermittelte Richtungsinformation wird dabei verwendet, um den Ort der HF-Quelle anzuzeigen. Hierzu sind auch eine Videokamera und ein Display vorgesehen.

Die US 5,886,672 beschreibt eine Antenne mit einem starren Ausleger und einer Vielzahl von flexiblen Antennenelementen, die an dem Ausleger befestigt sind. Die Antennenelemente haben gekrümmte Querschnitte und sind aus einem Material hergestellt, das es ihnen ermöglicht, sich bei Kontakt mit einem Objekt elastisch zu biegen. Die Antenne eignet sich für den Einsatz im mobilen Bereich, z. B. zur Verfolgung von Objekten, die mit Hochfrequenzsendern gekennzeichnet sind. Bei einem solchen Einsatz biegen sich die flexiblen Antennenelemente leicht, wenn sie mit Objekten, wie Ästen, Gestrüpp und anderer Vegetation, in Berührung kommen, so dass sie sich nicht verheddern und die Bewegung der Antenne verhindern.

Die US 4,199,246 beschreibt ein Ultraschall-Entfernungsmesssystem für eine Kamera, welches einen Ultraschallwandler, der auf einen Tastimpuls reagiert, umfasst, um einen frequenzmodulierten Burst von Ultraschallenergie in Richtung eines Objekts zu senden. Das System umfasst auch einen Empfänger zur Verarbeitung eines Echosignals, das von dem Wandler beim Empfang eines Echos innerhalb eines vorbestimmten Zeitintervalls nach dem Burst erzeugt wird, und zur Erzeugung eines Entfernungssignals mit einer Charakteristik, die linear mit der Entfernung eines fotografierten Objekts von der Kamera zusammenhängt.

### ZUSAMMENFASSUNG DER ERFINDUNG

Vor diesem Hintergrund liegt der Erfindung die Aufgabe zugrunde, eine verbesserte Wiedererkennbarkeit einer erfassten Störquelle bereitzustellen.

Erfindungsgemäß wird diese Aufgabe durch eine Richtantenne, eine Messanordnung und ein Verfahren mit den Merkmalen der unabhängigen Patentansprüche gelöst. Weitere vorteilhafte Ausführungsformen sind Gegenstand der abhängigen Ansprüche.

Die der vorliegenden Erfindung zugrunde liegende Idee besteht darin, eine an sich bekannte Richtantenne mit einer im Gehäuse der der Richtantenne mitintegrierten Kamera auszustatten. Diese mitintegrierte, eingebaute Kamera ermöglicht neben der herkömmlichen Dokumentation der Peilinformationen mittels der Richtantennenfunktion eine zusätzliche optische Dokumentation der Umgebung der Störquelle in einem variablen Detailgrad, etwa durch eine Nah- oder Fernaufnahme. Die vorliegende Erfindung stellt durch die so gewonnenen optischen Zusatzinformationen eine einfache, aber nichtsdestotrotz sehr effektive weiterentwickelte Dokumentationsmöglichkeit von Störquellen und deren Umgebung bereit. Somit muss bei der Suche nach Funkstörungen keine separate Kamera zur Aufnahme von Bildinformationen mitgeführt werden, was den Komfort für einen Anwender steigert.

Vorteilhafte Ausgestaltungen und Weiterbildungen ergeben sich aus den weiteren Unteransprüchen sowie aus der Beschreibung unter Bezugnahme auf die Figuren der Zeichnung.

Gemäß einer bevorzugten Ausführungsform ist die Kamera als Digitalkamera ausgebildet. Eine Digitalkamera weist üblicherweise einen integrierten Speicher auf, der erfindungsgemäß dazu verwendet wird, erfasste Peildaten und Bildinformationen abzuspeichern. Insbesondere ist es damit möglich, die von der Richtantenne aufgenommenen Peildaten und die von deren Kamera aufgenommenen Bildinformation zusammengehörig abzuspeichern. Dadurch werden automatisch den erfassten Peildaten die jeweils zugehörigen Bildinformationen zugeordnet, was ein späteres Auswerten vereinfacht. Zudem erspart dies personellen Arbeitsaufwand, da die genannten Daten nicht mehr in einer nachfolgenden Bearbeitung der Daten eigens identifiziert und zusammengeführt werden müssen. Durch diese Art der zusammengehörigen Datenspeicherung lassen sich zudem auch Fehler durch eine nachfolgende fehlerhafte Zusammenführung der Daten vermeiden, z.B. weil der Benutzer nicht mehr nachvollziehen kann, welche Bilddaten zu welchen Bildinformationen gehören. Alternativ ist es auch denkbar, die Kamera als Analogkamera, CCD-Sensor oder dergleichen auszubilden.

Gemäß einer weiteren bevorzugten Ausführungsform weist die Richtantenne einen GPS-Sensor auf. Dieser GPS-Sensor ist dazu ausgebildet, GPS-Positionsdaten des Ortes zu ermitteln, an dem die Peildaten und/oder die Bildinformation aufgenommen wurden. GPS-Daten sind besonders bei der Suche nach Störquellen außerhalb von Gebäuden und in einer weitläufigen Umgebung vorteilhaft, da auf diese Weise eine mehr oder weniger eindeutige Position der Störquelle vorhanden ist. Besonders vorteilhaft ist es, wenn die Peildaten und/oder die Bildinformation gewissermaßen mit einem elektronischen GPS-Positionsstempel versehen werden. Alternativ können zusammengehörige GPS-Positionsdaten, Peildaten und/oder Bildinformation auch getrennt voneinander abgespeichert werden.

Gemäß einer weiteren Ausführungsform weist die Richtantenne zudem eine Einrichtung zur Zeiterfassung auf, um zu den Peildaten und/oder Bildinformationen zugehörige Zeitinformationen zu erhalten. Die Zeitinformation kann beispielsweise als Zeitstempel bezogen auf die Peildaten bzw. Bildinformationen gespeichert werden. Hierdurch ist sichergestellt, dass auch bei großen Datenmengen zugehörige Peildaten und Bildinformation exakt identifiziert werden. Zudem ist die Dokumentation einer Uhrzeit, eines Datums und/oder einer Zeitdauer besonders bei solchen Störsignalen von Bedeutung und vorteilhaft, die lediglich temporär, intervallweise, etc. auftreten. Des Weiteren lässt sich durch eine Zuordnung von Peildaten zu einer Zeitinformation auch ein Rauschen, welches dem elektromagnetischen Signal möglicherweise überlagert ist, dokumentieren.

Erfindungsgemäß verfügt die Richtantenne über eine mit der Kamera gekoppelte Steuereinrichtung, die dazu ausgebildet ist, die Kamera abhängig von einer vorgegebenen Bedingung automatisch auszulösen. Die vorgegebene Bedinbezeichnet zumindest das Überschreiten eines Schwellwerts bezüglich des elektromagnetischen Signals. Der Schwellwert bezüglich des elektromagnetischen Signals kann beispielsweise eine Amplitude, eine Signalintensität, eine Signalstreuung, ein bestimmtes vorgegebenes Rauschen und/oder eine Frequenz des elektromagnetischen Störsignals sein. Z.B. kann vorgesehen sein, das die Kamera automatisch auslöst, wenn die Richtantenne ein erfasstes Signal als Störsignal qualifiziert, z.B. anhand der Signalcharakteristik. Alternativ kann die vorgegebene Bedingung in einer nicht-erfindungsgemäßen Ausführungsform auch eine Zeitangabe sein. Z.B. wäre denkbar, die Kamera intervallweise, etwa alle 30 Sekunden, auszulösen. Denkbar wären natürlich auch andere Bedingungen. Alternativ wäre denkbar, wenn die Steuereinrichtung die Kamera benutzerabhängig, z.B. auf eine Tasteneingabe durch einen Benutzer hin, auslöst.

Weiter vorteilhaft ist es, wenn die vorgegebene Bedingung benutzerspezifisch, insbesondere während des Betriebs der Richtantenne, einstellbar ist. Dadurch ist gewährleistet, dass die Steuereinrichtung an spezifische Verhältnisse, wie etwa Umgebungsverhältnisse (z.B. Peilung im geschlossenen Gebäude, innerorts, etc.) angepasst wird.

Die Richtantenne weißt eine Distanzmesseinrichtung auf. Mittels der Distanzmesseinrichtung kann ein Abstand zwischen der Richtantenne und der Störquelle ermittelt werden, wodurch einerseits ebenfalls eine verbesserte Positionsbestimmung der Störquelle möglich ist. Zudem lässt sich dadurch die Qualität des ausgesendeten und durch die Richtantenne empfangenen Störsignals besser bewerten. Vorzugsweise ist die Distanzmesseinrichtung als Richtmikrofon ausgebildet. Ein Richtmikrofon ist ein Mikrofontyp, der primär den frontal eintreffenden Schall aufnimmt und dadurch eine Richtcharakteristik aufweist. Schall aus anderen Richtungen wird stärker gedämpft in elektrische Signale umgesetzt. Mittels eines Richtmikrofons lässt sich die Distanz aufgrund einer Laufzeitdifferenz zwischen dem elektromagnetischen Signal und einem Schallsignal, welches zeitgleich zu dem elektromagnetischen Signal von der Störquelle ausgesendet wurde, ermitteln.

Gemäß einer weiteren Ausführungsform ist ein derartiger Richtantennentyp vorgesehen, welcher zum Empfang von elektromagnetischen Signalen in einem Frequenzbereich zwischen 9 kHz und 7,5 GHz ausgebildet ist. Vorzugsweise existieren jeweils für Störsignale mit unterschiedlicher Frequenz unterschiedliche Richtantennentypen. Besonders vorteilhaft ist es, wenn die Richtantenne zum Empfang von elektromagnetischen Signalen in einem Frequenzbereich zwischen 9 kHz und 20 MHz und/oder zwischen 20 MHz und 200 MHz und/oder zwischen 200 MHz und 500 MHz und/oder 500 MHz und 7,5 GHz ausgebildet ist.

In einer besonders bevorzugten Weiterbildung ist die erfindungsgemäße Richtantenne dazu ausgebildet, Störsignale, welche von einer Störquelle ausgesendet werden, zu erfassen, zu lokalisieren und zu dokumentieren. Vorzugsweise erfolgt dies vollautomatisch unter Einbeziehung der Steuereinrichtung. Unter dem Begriff "dokumentieren" wird z.B. das Speichern sämtlicher erfasster Daten, die in Bezug mit der Störquelle stehen, verstanden.

Gemäß einer ebenfalls bevorzugten Ausführungsform der Messanordnung ist eine Eingabevorrichtung vorgesehen, um weitere Informationen, z.B. bezüglich der Position, der Beschaffenheit, der Art etc. der Störquelle durch eine Benutzereingabe zu dokumentieren. Die Eingabevorrichtung kann typischerweise als Taste, Tastatur, Touchpad, als haptischer Sensor, als Mikrofon mit Spracherkennung, als Gestenerkennung, etc. ausgebildet sein. Auf diese Weise lassen sich Zusatzinformationen, etwa im Hinblick auf die Qualität der Daten oder hinsichtlich einer Beschreibung verschiedener in Frage kommender Störquellen, Anmerkungen des Benutzers, etc. besonders einfach aufzeichnen und den erfassten Daten zuordnen.

Gemäß einer weiteren Ausführungsform der Messanordnung ist eine Steuereinrichtung vorgesehen, um die benutzerspezifischen Eingaben den aufgenommenen Bildinformationen und/oder den erfassten Peildaten zuzuordnen. Auf diese Weise lassen sich die erfassten Informationen, wie etwa die erfassten Peildaten, Bildinformationen, GPS-Daten, Zeitinformationen, Benutzereingaben, etc. als zusammengehörige Informationen abspeichern.

Gemäß einer weiteren Ausführungsform der Messanordnung ist eine Anzeigevorrichtung vorgesehen. Mittels der Anzeigevorrichtung lassen sich die erfassten Informationen, wie etwa die erfassten Peildaten, Bildinformationen, GPS-Daten, Zeitinformationen, Benutzereingaben, etc., einzeln oder als zusammengehörige Informationen anzeigen. Die Anzeigevorrichtung ist z.B. als Monitor, Display, Bildschirm, wie etwa ein LCD-Bildschirm, Plasma-Bildschirm, FED-Bildschirm, CRT-Bildschirm und dergleichen, ausgebildet.

Die obigen Ausgestaltungen und Weiterbildungen lassen sich, sofern sinnvoll, beliebig miteinander kombinieren. Weitere mögliche Ausgestaltungen, Weiterbildungen und Implementierungen der Erfindung umfassen auch nicht explizit genannte Kombinationen von zuvor oder im Folgenden bezüglich der Ausführungsbeispiele beschriebenen Merkmale der Erfindung. Insbesondere wird dabei der Fachmann auch Einzelaspekte als Verbesserungen oder Ergänzungen zu der jeweiligen Grundform der vorliegenden Erfindung hinzufügen.

### INHALTSANGABE DER ZEICHNUNGEN

Die vorliegende Erfindung wird nachfolgend anhand der in den schematischen Figuren der Zeichnungen angegebenen Ausführungsbeispiele näher erläutert. Es zeigen dabei:
- Fig. 1: eine erste, allgemeine Ausführungsform einer erfindungsgemäßen Richtantenne;
- Fig. 2-5: weitere Ausführungsformen einer erfindungsgemäßen Richtantenne;
- Fig. 6: ein Ablaufdiagramm zur Erläuterung des erfindungsgemäßen Verfahrens;
- Fig. 7A-7D: weitere Ausführungsformen einer erfindungsgemäßen Richtantenne;
- Fig. 8: eine weitere Ausführungsform einer erfindungsgemäßen Messanordnung.

Die beiliegenden Zeichnungen sollen ein weiteres Verständnis der Ausführungsformen der Erfindung vermitteln. Sie veranschaulichen Ausführungsformen und dienen im Zusammenhang mit der Beschreibung der Erklärung von Prinzipien und Konzepten der Erfindung. Andere Ausführungsformen und viele der genannten Vorteile ergeben sich im Hinblick auf die Zeichnungen. Die Elemente der Zeichnungen sind nicht notwendigerweise maßstabsgetreu zueinander gezeigt.

In den Figuren der Zeichnungen sind gleiche, funktionsgleiche und gleichwirkende Elemente, Merkmale und Komponenten - sofern nicht anders ausgeführt- jeweils mit denselben Bezugszeichen versehen.

### BESCHREIBUNG VON AUSFÜHRUNGSBEISPIELEN

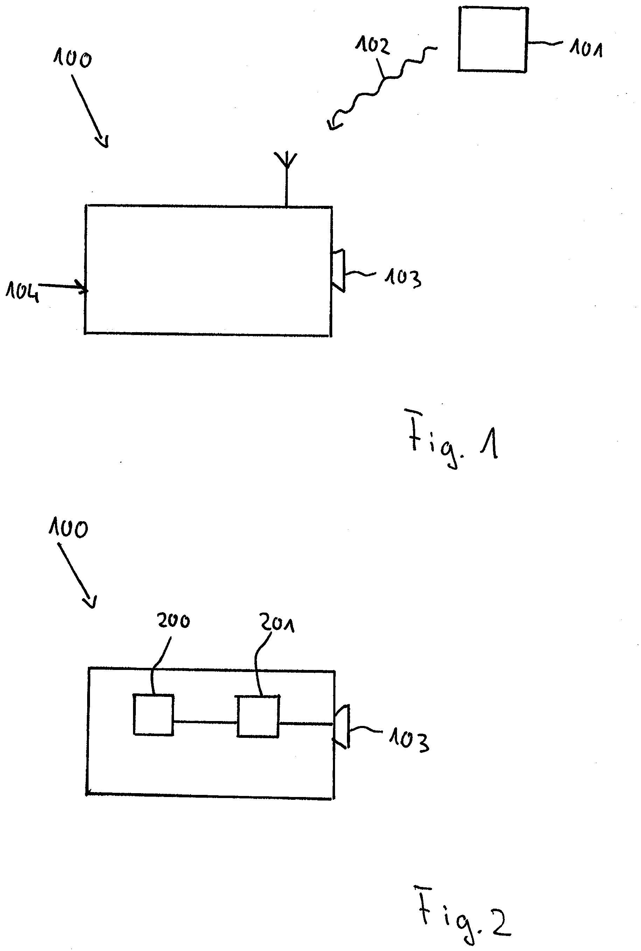

Figur 1 zeigt eine schematische Darstellung eines ersten, allgemeinen Ausführungsbeispiels einer erfindungsgemäßen Richtantenne 100 zur Ortung von Funkstörquellen. Die Richtantenne 100 ist dazu ausgebildet, ein elektromagnetisches Signal 102, das beispielsweise von einer Störquelle 101, wie etwa einem defekten Hausgerät, einem Mobilfunksender oder dergleichen, erzeugt und ausgestrahlt wird, aufzunehmen und zu analysieren.

Die erfindungsgemäße Richtantenne 100 weist eine Kamera 103 auf, welche eine Analogkamera oder Digitalkamera sein kann und welche zum Beispiel im Gehäuse 104 der Richtantenne 100 eingebettet ist. Mittels der erfindungsgemäßen Richtantenne 100 mit integrierter Kamera 103 wird eine funktionserweiterte Richtantenne 100 bereitgestellt. Insbesondere ermöglicht die Richtantenne 100 eine besonders effiziente und komfortable Dokumentation zum Ort, zur Umgebung, zur genauen Position, zur Art und Beschaffenheit, etc. der Störquelle 101, indem mittels der Kamera 103 eine Bildinformation der Störquelle 101 oder dessen Umgebung aufgenommen wird.

Die Kamera 103 kann als Fotokamera zur Aufnahme einzelner Bilder oder als Videokamera zur Aufnahme von Bildsequenzen ausgebildet sein.

Figur 2 zeigt eine schematische Darstellung eines weiteren Ausführungsbeispiels einer erfindungsgemäßen Richtantenne 200. Die Richtantenne 100 umfasst hier ein Speichermedium 200 zum Speichern der von der Kamera 103 aufgenommenen Bildinformationen sowie weiterer Informationen, wie etwa Peildaten. Im Falle einer Digitalkamera 103 kann das Speichermedium 200 bereits in der Kamera 103 mitintegriert sein. Das Speichermedium 200 ist in diesem Fall ein elektronischer Speicher 200, wie etwa ein DRAM, SRAM, Graphik-Speicher, eine Speicherkarte, eine Festplatte oder dergleichen. Denkbar wäre auch, dass das Speichermedium 200 als externer Speicher ausgebildet ist und z.B. über eine (hier nicht gezeigte) I/O-Schnittstelle an die Richtantenne 100 ankoppelbar ist.

Die Richtantenne 100 umfasst ferner eine Steuereinrichtung 201, welche sowohl mit der Kamera 103 als auch dem Speicher 200 gekoppelt ist. Die Steuereinrichtung 201 steuert dabei die Funktion der Richtantenne 100 sowie deren Kamera 103 und Speicher 200. ist vorgesehen, dass die Steuereinrichtung 201 die Kamera 103 abhängig von einer vorgegebenen Bedingung automatisch auslöst. Die vorgegebene Bedingung ist das Überschreiten eines bestimmten, vorgegebenen Schwellwertes, z.B. bezüglich der Amplitude, Intensität, Streuung und/oder der Frequenz des erfassten elektromagnetischen Störsignals 102.

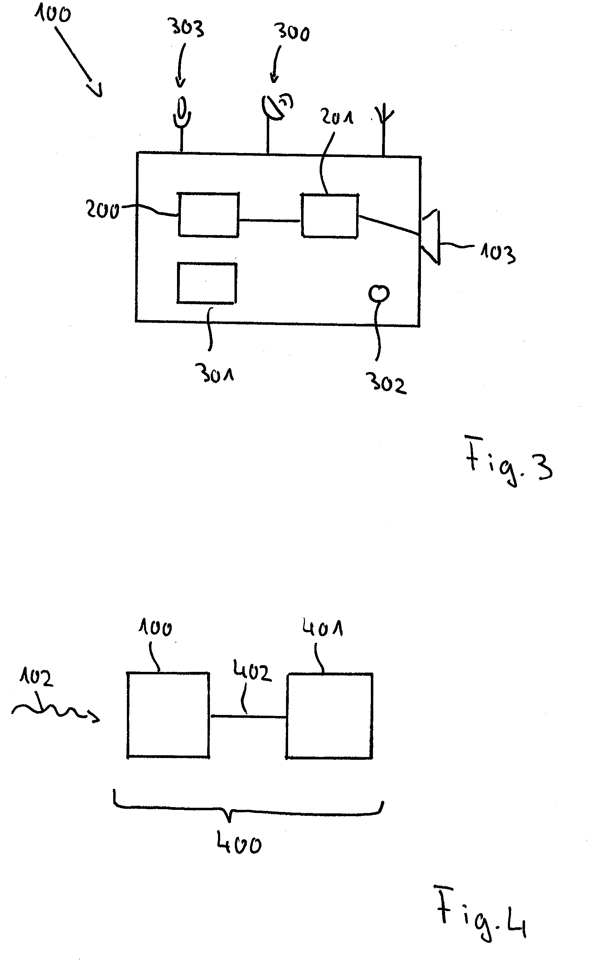

Figur 3 zeigt eine schematische Darstellung einer weiteren Ausführungsform einer erfindungsgemäßen Richtantenne 100. Die Richtantenne 100 umfasst hier neben der Kamera 103, Speicher 200 und Steuereinrichtung 201 einen GPS-Sensor 300 zur Bestimmung der Position der Richtantenne 100. Der GPS-Sensor 300 ist mit dem Speicher 200 gekoppelt, um dort die gewonnenen Positionsdaten zu speichern. Somit ermöglicht der GPS-Sensor 300, dass von der Kamera 103 erfasste Bildinformationen und von der Richtantenne 100 erfasste Peildaten jeweils mit einem Positionsstempel versehen werden, so dass zusammengehörige Bild- und Peildaten später anhand des Positionsstempels einfacher identifiziert werden können.

Die Richtantenne 100 weist ferner eine Einrichtung 301 zur Zeiterfassung auf. Da Daten, welche (nahezu) zur gleichen Zeit erfasst wurden, in der Regel auch (nahezu) am gleichen Ort erfasst wurden, lässt sich mittels der Einrichtung 301 auch eine besonders genaue Positionszuordnung der erfassten Daten vornehmen.

Ferner weist die Richtantenne 100 eine Betätigungseinrichtung 302 zur Betätigung der Kamera 103 auf. In diesem Ausführungsbeispiel ist die Betätigungseinrichtung 302 als Auslösetaste 302 ausgebildet, mittels welcher die Kamera 103 von einem Anweder ausgelöst wird. Mittels der Betätigungseinrichtung 302 könnte jedoch auch die Kamera 103 gesteuert werden.

Die Richtantenne 100 weist weiterhin ein Richtmikrofon 303 zum Empfangen eines Schallsignals, welches von einer Störquelle 101 zeitgleich zu dem elektromagnetischen Störsignal 102 ausgesendet wird, auf. Mittels des Richtmikrofons 303 wird eine Laufzeitdifferenz zwischen der Laufzeit des elektromagnetischen Störsignals 102 und des Schallsignals ermittelt, anhand der sich ein Abstand von Störquelle 101 zur Richtantenne 100 ermitteln lässt.

Zur leichteren Handhabbarkeit durch einen Anwender ist die Richtantenne 100 zudem mit einem Griff 304 ausgestattet.

Figur 4 zeigt eine schematische Darstellung eines ersten Ausführungsbeispiels einer erfindungsgemäßen Messanordnung 400 zur Erfassung und Ortung von elektrischen Funkstörquellen. Die Messanordnung 400 umfasst eine Richtantenne 100, wie sie z.B. vorstehend anhand der Figuren 1 bis 3 beschrieben wurde, sowie einen Spektrumanalysator 401.

Ein Spektrumanalysator 401 ist ein in der elektrischen Messtechnik eingesetztes Messgerät zur Erfassung und Darstellung eines Signals im Frequenzbereich. Die Darstellung erfolgt üblicherweise auf einem in das Messgerät eingebauten Bildschirm, wobei die horizontale Achse (Abszisse) die Frequenzachse ist und die Amplitude des Signals auf der vertikalen Achse (Ordinate) abgebildet wird. Das so entstehende Bild wird als Frequenzspektrum bezeichnet. Spektrumanalysatoren 401 werden unter anderem im Bereich der Hochfrequenztechnik eingesetzt.

Mit der erfindungsgemäßen Messanordnung 400 ist es möglich, ein elektromagnetisches Störsignal 102 mittels des Spektrumanalysators 401 zunächst zu erfassen und zu charakterisieren sowie das erfasste und charakterisierte Störsignal 102 anschließend mittels der Richtantenne 100 zu lokalisieren.

Die Messanordnung 400 kann einteilig ausgebildet sein. In diesem Falle wäre der Spektrumanalysator 401 bereits in der Richtantenne 100 integriert (oder umgekehrt). Es ist jedoch vorteilhaft, wenn die Messanordnung 400 zweiteilig auszubilden, wie dies in Figur 4 gezeigt ist. In diesem Fall umfasst ein erster Teil der Messanordnung 400 die Richtantenne 100 und ein zweiter Teil der Messanordnung 400 umfasst den Spektrumanalysator 401. In diesem Fall wären die Richtantenne 100 und der Spektrumanalysator 401 z.B. mittels einer Funkverbindung oder einem Verbindungskabel 402 miteinander zu koppeln.

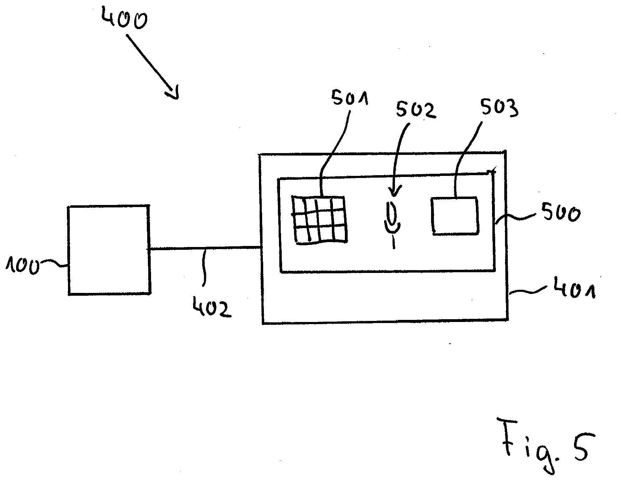

Fig. 5 zeigt eine weitere Ausführungsform einer erfindungsgemäßen Messanordnung 400. Der Spektrumsanalysator 401 umfasst hier eine Eingabevorrichtung 500, über welche benutzerspezifische Zusatzinformationen eingebbar sind und zusammen mit den zugehörigen Peildaten und Bildinformationen abgespeichert werden können. Die Eingabevorrichtung 500 umfasst hier eine Tastatur 501, ein Mikrofon 502 für die Eingabe einer Sprachnotiz sowie einen Touchscreen 503.

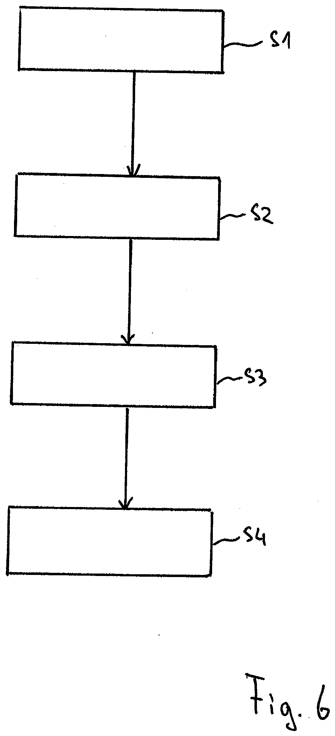

Fig. 6 zeigt ein Ablaufdiagramm zur Erläuterung der einzelnen Schritte des erfindungsgemäßen Verfahrens zum Messen eines von einer Störquelle ausgesendeten elektromagnetischen Signals.

In einem ersten Schritt S1 wird zunächst ein von einer Störquelle erzeugtes elektromagnetisches Störsignal erfasst und ausgewertet, indem z.B. eine Charakteristik des Störsignals hinsichtlich dessen Frequenz, Amplitude, Intensität, etc. analysiert wird.

In einem weiteren Schritt S2 wird eine Einfallsrichtung des erfassten elektromagnetischen Signals bestimmt.

Dabei können die Schritte S1, S2 iterativ wiederholt werden, damit sich der Anwender der Störquelle bestmöglich nähern kann.

Während oder im Anschluss an diese Such- und Optimierungsschritte S1 und S2 wird im Schritt S3 zumindest ein Bild der Umgebung, in der das elektromagnetische Signal detektiert wurde, aufgenommen.

In einem anschließenden Schritt S4 werden die ermittelten Daten und Informationen, wie sie in den Schritten S1, S2 und S3 aufgenommen bzw. gemessen wurden, abgespeichert. Um den Nachbearbeitungsaufwand zu reduzieren, werden zugehörige Daten zusammenhängend abgespeichert oder derart gekennzeichnet, dass zusammengehörige Daten nach dem Abspeichern von einem Sortieralgorithmus als zusammengehörig erkannt werden können.

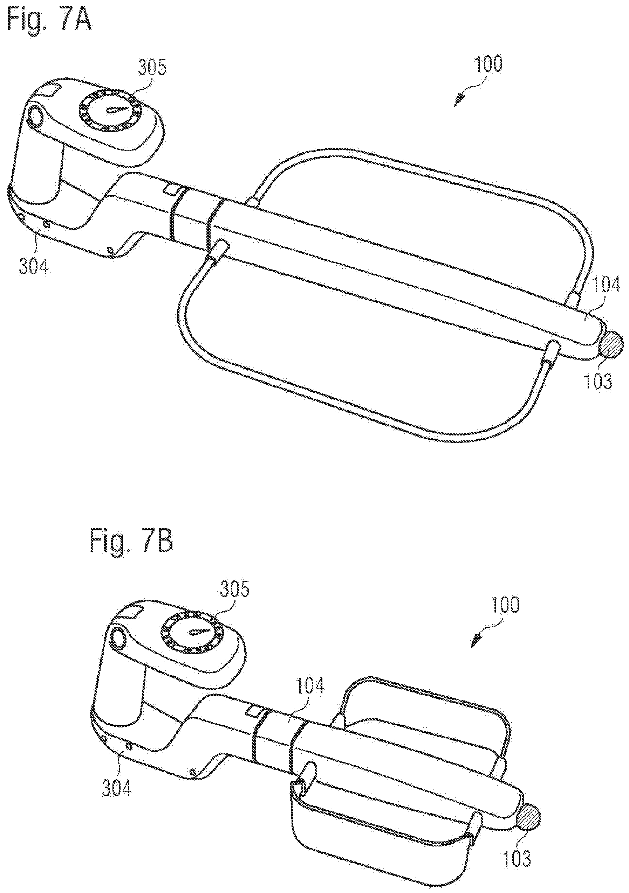

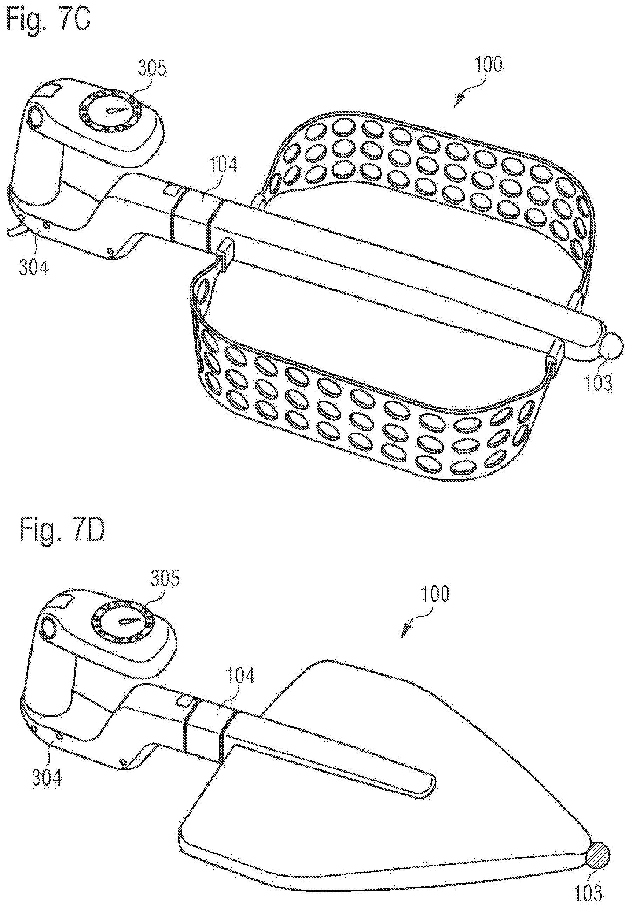

Die Figuren 7A - 7D zeigen weitere Ausführungsbeispiele einer erfindungsgemäßen Richtantenne 100. Statt einem GPS-Sensor 300 wie in dem Ausführungsbeispiel in Figur 3 ist diese Richtantenne 100 für die Positionsbestimmung mit einem Kompass 305 ausgestattet. Die verschiedenen Richtantennen 100 der Figuren 7A - 7D zeichnen sich durch unterschiedliche Empfangsempfindlichkeit der zu erfassenden Störsignale aus. So ist z.B. die Richtantenne 100 in Figur 7A für einen Frequenzbereich von 9 kHz bis 20 MHz ausgelegt. Die Richtantenne 100 in Figur 7B ist für einen Frequenzbereich von 200 MHz bis 500 MHz ausgelegt. Die Richtantenne 100 in Figur 7C ist für einen Frequenzbereich von 20 MHz bis 200 MHz ausgelegt. Die Richtantenne 100 in Figur 7D ist für einen Frequenzbereich von 0,5 GHz bis 7,5 GHz ausgelegt.

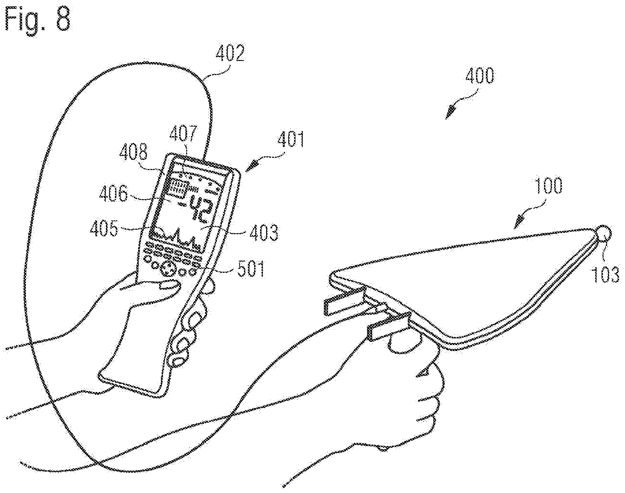

Figur 8 zeigt ein weiteres Ausführungsbeispiel einer erfindungsgemäßen Messanordnung 400 mit einem Spektrumanalysator 401 und einer Richtantenne 100. In diesem Ausführungsbeispiel in Fig. 8 ist der Spektrumanalysator 401 mit der Richtantenne 100 über ein Koaxialkabel 404 verbunden. Alternativ kann auch eine drahtlose Kopplung von Spektrumanalysator 401 und der Richtantenne 100 vorgesehen sein, zum Beispiel mittels Bluetooth, IR, Funk, etc.

Der Spektrumanalysator 401 weist hier eine als Tastatur 501 ausgebildete Eingabevorrichtung 500 auf. Zudem ist ein Display 403 vorgesehen, auf welchem von der Richtantenne 100 ermittelte Daten des Störsignals angezeigt werden. In diesem Ausführungsbeispiel zeigt das Display 403 ein Frequenzspektrum 405 des erfassten Störsignals. Zudem wird die von dem Spektrumanalysator 401 erfasste Signalintensität 406 dargestellt. Ferner zeigt das Display 403 die von der Richtantenne 100 erfassten Peildaten auf einer Winkelskala 407. Erfindungsgemäß wird auf dem Dislay 403 nun auch ein von der Kamera 103 aufgenommenes Bild 408 angezeigt.

### BEZUGSZEICHENLISTE

- 100: Richtantenne
- 101: Störquelle
- 102: Störsignal
- 103: (Analog- oder Digital-)Kamera
- 104: Gehäuse

- 200: Speicher
- 201: Steuereinrichtung

- 300: GPS-Sensor
- 301: Einrichtung zur Zeiterfassung
- 302: Betätigungseinrichtung
- 303: Richtmikrofon, Distanzmesseinrichtung
- 304: Griff
- 305: Kompass

- 400: Messanordnung
- 401: Spektrumanalysator
- 402: Verbindungskabel
- 403: Display
- 404: Koaxialkabel
- 405: Frequenzspektrum
- 406: Intensität
- 407: Winkelskala
- 408: (Kamera-)Bild

- 500: Eingabevorrichtung
- 501: Tastatur
- 502: Mikrofon
- 503: Touchscreen

- S1-S4: Schritte

## Patentansprüche

1. Tragbare Richtantenne (100), die dazu ausgebildet ist, Peildaten einer ein elektromagnetisches Störsignal (102) aussendenden Störquelle (101) zu erfassen,
mit einer eingebauten Kamera (103), die dazu ausgelegt ist, Bildinformationen von der Umgebung der Richtantenne (100), insbesondere von der Umgebung der Störquelle (101), aufzunehmen,
mit einer Steuereinrichtung (201), welche mit der Kamera (103) gekoppelt ist und welche derart ausgebildet ist, die Kamera (103) abhängig von einer vorgegebenen Bedingung automatisch auszulösen, wobei die vorgegebene Bedingung das Überschreiten zumindest eines Schwellwerts bezüglich des erfassten elektromagnetischen Störsignals (102) bezeichnet.

2. Richtantenne nach Anspruch 1,
**dadurch gekennzeichnet,**
**dass** die Kamera (103) als Digitalkamera (103) ausgebildet ist, welche einen Speicher (200) aufweist, um von der Digitalkamera (103) aufgenommene Bildinformationen und/oder zu den Bildinformationen zugehörige Peildaten zu speichern.

3. Richtantenne nach einem der vorstehenden Ansprüche, **dadurch gekennzeichnet,**
**dass** ein GPS-Sensor (300) vorgesehen ist, der dazu ausgebildet ist, zu den Peildaten und/oder Bildinformationen zugehörige GPS-Positionsdaten zu erfassen.

4. Richtantenne nach einem der vorstehenden Ansprüche, **dadurch gekennzeichnet,**
**dass** eine Einrichtung zur Zeiterfassung (301) vorgesehen ist, die dazu ausgebildet ist, zu den Peildaten und/oder Bildinformationen zugehörige Zeitinformationen zu erfassen.

5. Richtantenne nach einem der vorstehenden Ansprüche, **dadurch gekennzeichnet,**
**dass** der zumindest eine Schwellwert ein Schwellwert der Amplitude, Intensität, Streuung und/oder der Frequenz des erfassten elektromagnetischen Störsignals (102) bezeichnet.

6. Richtantenne nach einem der vorherigen Ansprüche, **dadurch gekennzeichnet,**
**dass** die vorgegebene Bedingung über eine Eingabeeinrichtung (500) benutzerspezifisch einstellbar ist.

7. Richtantenne nach einem der vorstehenden Ansprüche, **dadurch gekennzeichnet,**
**dass** eine Distanzmesseinrichtung (303), insbesondere ein Richtmikrofon (303), vorgesehen ist, welche derart angeordnet und dazu ausgebildet ist, eine Distanz zwischen der Richtantenne (100) und der Störquelle (101) zu bestimmen.

8. Richtantenne nach einem der vorstehenden Ansprüche, **dadurch gekennzeichnet,**
**dass** die Richtantenne (100) zum Empfang von elektromagnetischen Störsignalen (102) in einem Frequenzbereich zwischen 9 kHz und 7,5 GHz, insbesondere in einem Frequenzbereich zwischen 9 kHz und 20 MHz und/oder in einem Frequenzbereich zwischen 20 MHz und 200 MHz und/oder in einem Frequenzbereich zwischen 200 MHz und 500 MHz und/oder in einem Frequenzbereich zwischen 500 MHz und 7,5 GHz ausgebildet ist.

9. Messanordnung (400),
mit einer Richtantenne (100) nach einem der vorstehenden Ansprüche,
mit einem als Spektrumanalysator (401) ausgebildeten Messgerät, welches mit der Richtantenne (100) gekoppelt ist und welches dazu ausgebildet ist, ein von der Richtantenne (100) aufgenommenes elektromagnetisches Störsignal (102) zu analysieren.

10. Messanordnung nach Anspruch 9,
**dadurch gekennzeichnet,**
**dass** eine Eingabevorrichtung (500) vorgesehen ist, über welche benutzerspezifische Eingaben bezüglich der Position und/oder der Beschaffenheit der das erfasste elektromagnetische Störsignal (102) aussendenden Störquelle (101) eingebbar sind.

11. Messanordnung nach Anspruch 10,
**dadurch gekennzeichnet,**
**dass** die Steuereinrichtung (201)
dazu ausgebildet ist, die benutzerspezifischen Eingaben den aufgenommenen Bildinformationen und/oder erfassten Peildaten zuzuordnen und die so miteinander verknüpften Informationen als zusammengehörige Information in einem Speicher (200) abzuspeichern.

12. Messanordnung nach einem der Ansprüche 10 bis 11, **dadurch gekennzeichnet,**
**dass** eine Anzeigevorrichtung (403), insbesondere ein Display (403) oder ein Monitor, vorgesehen ist, welche dazu ausgebildet ist, aufgenommene Bildinformationen, erfasste Peildaten, GPS-Daten, Zeitinformationen, benutzerspezifischen Eingaben und/oder vom Spektrumanalysator (401) ausgewertete Daten anzuzeigen.

13. Verfahren zur Lokalisation einer Funkstörquelle, mit den Schritten:
Bereitstellen einer tragbaren Richtantenne (100), die dazu ausgebildet ist, Peildaten einer ein elektromagnetisches Störsignal (102) aussendenden Störquelle (101) zu erfassen, und die eine eingebaute Kamera (103) umfasst;
Bestimmen der Position einer Störquelle (101) durch Erfassen (S1) und Auswerten eines von der Störquelle (101) ausgesendeten elektromagnetischen Störsignals (102) und durch Bereitstellen (S2) von Peildaten aus einer Einfallsrichtung des erfassten elektromagnetischen Störsignals (102);
Bestimmen des Vorhandenseins einer vorgegebenen Bedingung, wobei die vorgegebene Bedingung das Überschreiten zumindest eines Schwellwerts bezüglich des erfassten elektromagnetischen Störsignals (102) bezeichnet;
abhängig von der bestimmten vorgegebenen Bedingung, automatisches Auslösen der Kamera (103) zur Erfassung (S3) von Bildinformation der Umgebung der Störquelle (101) und/oder eines Ortes, an dem das elektromagnetische Störsignal (102) erfasst wurde;
Abspeichern (S4) der bestimmten Position sowie der zugehörigen Bildinformation.

14. Verfahren nach Anspruch 13, welches zumindest einen der nachfolgenden weiteren Schritte umfasst:
- Ermitteln einer Distanz zwischen der Störquelle (101) des elektromagnetischen Signals und einem Ort, an dem das elektromagnetische Störsignal (102) erfasst wurde;
- Charakterisieren des erfassten und ausgewerteten elektromagnetischen Störsignals (102);
- Anpassen eines Fokus und/oder eines Zooms der Aufnahme abhängig von der ermittelten Distanz;
- Anzeigen der aufgenommenen Bildinformation zusammen mit weiteren Informationen, welche die Störquelle (101) betreffen;
- Ermitteln von GPS-Positionsdaten des Ortes, an dem die Position der Störquelle (101) bestimmt wurde;
- Ermitteln von Zeitdaten des Zeitpunktes, zu welchem die Position der Störquelle (101) bestimmt wurde;
- Einblenden einer Information über die erfasste Einfallsrichtung des elektromagnetischen Störsignals (102) in der Bildinformation.

## Claims

1. A portable directional antenna (100), which is designed to detect bearing data of an interference source (101) transmitting an electromagnetic interference signal (102),
with a built-in camera (103), which is designed to record image information from the surroundings of the directional antenna (100), in particular from the surroundings of the interference source (101),
with a control device (201), which is coupled with the camera (103) and which is configured in such a way to automatically trigger the camera (103) dependent on a specified condition, wherein the specified condition denotes the exceeding of at least one threshold value with respect to the detected interference signal (102).

2. The directional antenna according to claim 1, **characterized in that**
the camera (103) is configured as a digital camera (103), which has a memory (200) in order to store image information recorded by the digital camera (103) and/or to store bearing data belonging to the image information.

3. The directional antenna according to any of the preceding claims,
**characterized in that**
a GPS sensor (300) is provided, which is configured to detect GPS position data belonging to the bearing data and/or image information.

4. The directional antenna according to any of the preceding claims,
**characterized in that**
a device for time detection (301) is provided, which is configured to detect time information belonging to the bearing data and/or image information.

5. The directional antenna according to any of the preceding claims,
**characterized in that**
the at least one threshold value denotes a threshold value of the amplitude, intensity, scatter and/or frequency of the detected electromagnetic interference signal (102).

6. The directional antenna according to any of the preceding claims,
**characterized in that**
the specified condition is user-specific adjustable via an input device (500).

7. The directional antenna according to any of the preceding claims,
**characterized in that**
a distance measuring device (303), in particular a directional microphone (303) is provided, which is arranged and configured to determine a distance between the directional antenna (100) and the interference source (101).

8. The directional antenna according to any of the preceding claims,
**characterized in that**
the directional antenna (100) is configured to receive electromagnetic signals (102) in a frequency range between 9 kHz and 7.5 GHz, in particular in a frequency range between 9 kHz and 20 MHz and/or in a frequency range between 20 MHz and 200 MHz and/or in a frequency range between 200 MHz and 500 MHz and/or in a frequency range between 500 MHz and 7.5 GHz.

9. A measuring assembly (400),
with a directional antenna (100) according to any of the preceding claims,
with a measuring device configured as a spectrum analyzer (401), which is coupled with the directional antenna (100) and which is configured to analyze an electromagnetic interference signal (102) recorded by the directional antenna (100).

10. The measuring assembly according to claim 9, **characterized in that**
an input device (500) is provided, via which user specific input with respect to the position and/or the nature of the interference source (101) transmitting the recorded electromagnetic interference signal (102) can be input.

11. The measuring assembly according to claim 10, **characterized in that**
the control device (201) is configured to assign the user specific input to the recorded image information and/or the detected bearing data and to store the information thus linked as related information in a memory (200).

12. The measuring assembly according to any of claims 10 to 11,
**characterized in that**
a display device (403), in particular a display (403) or a monitor is provided, which is configured to display recorded image information, detected bearing data, GPS data, time information, user specific input and/or data evaluated by the spectrum analyzer (401).

13. A method for localization of a radio interference source, with the steps of:
providing a portable directional antenna (100), which is configured to detect bearing data of an interference source (101) transmitting an electromagnetic interference signal (102), and which comprises a built-in camera (103);
determining the position of an interference source (101) by detection (S1) and evaluation of an electromagnetic interference signal (102) transmitted by the interference source (101) and by providing (S2) bearing data from an incidence direction of the detected electromagnetic interference signal (102) ;
determining the presence of a specified condition, wherein the specified condition denotes the exceeding of a threshold value with respect to the detected electromagnetic interference signal (102);
dependent on the determined specified condition, automatic triggering of the camera (103) for the detection (S3) of image information of the surroundings of the interference source (101) and/or of a location, at which the electromagnetic interference signal (102) was detected;
storing (S4) the determined position as well as the associated image information.

14. The method according to claim 13, which comprises at least one of the following further steps:
- determining a distance between the interference source (101) of the electromagnetic signal and a location, at which the electromagnetic interference (102) was detected;
- characterizing the detected and evaluated electromagnetic interference signal (102);
- adapting a focus and/or a zoom of the photograph dependent on the determined distance;
- displaying the recorded image information together with further information which relates to the interference source (101);
- determining GPS position data of the location, at which the position of the interference source (101) was determined;
- determining time data of the time at which the position of the interference source (101) was determined;
- showing information about the detected incidence direction of the electromagnetic interference signal (102) in the image information.

## Revendications

1. Antenne directionnelle (100) portative, qui est réalisée pour acquérir des données de relèvement d'une source de brouillage (101) émettant un signal brouilleur électromagnétique (102),
avec une caméra (103) intégrée, qui est conçue pour enregistrer des informations d'image de l'environnement de l'antenne directionnelle (100), en particulier de l'environnement de la source de brouillage (101),
avec un système de commande (201), lequel est couplé à la caméra (103) et lequel est réalisé de manière à déclencher automatiquement la caméra (103) en fonction d'une condition prédéfinie, dans laquelle la condition prédéfinie désigne le dépassement d'au moins une valeur de seuil en ce qui concerne le signal brouilleur électromagnétique (102) acquis.

2. Antenne directionnelle selon la revendication 1, **caractérisée en ce**
**que** la caméra (103) est réalisée sous la forme d'une caméra numérique (103), laquelle présente une mémoire (200), pour mettre en mémoire les informations d'image enregistrées par la caméra numérique (103) et/ou les données de relèvement associées aux informations d'image.

3. Antenne directionnelle selon l'une quelconque des revendications précédentes,
**caractérisée en ce**
**qu'**un capteur GPS (300) est prévu, qui est réalisé pour acquérir des données de position GPS associées aux données de relèvement et/ou informations d'image.

4. Antenne directionnelle selon l'une quelconque des revendications précédentes,
**caractérisée en ce**
**qu'**un système d'acquisition de temps (301) est prévu, qui est réalisé pour acquérir des informations de temps associées au données de relèvement et/ou informations d'image.

5. Antenne directionnelle selon l'une quelconque des revendications précédentes,
**caractérisé en ce**
**que** la au moins une valeur de seuil désigne une valeur de seuil de l'amplitude, de l'intensité, de la diffusion et/ou de la fréquence du signal brouilleur électromagnétique (102) acquis.

6. Antenne directionnelle selon l'une quelconque des revendications précédentes,
**caractérisée en ce**
**que** la condition prédéfinie est réglable de manière spécifique à l'utilisateur par l'intermédiaire d'un système d'entrée (500).

7. Antenne directionnelle selon l'une quelconque des revendications précédentes,
**caractérisée en ce**
**qu'**un système de mesure de distance (303), en particulier un microphone directionnel (303), est prévu, lequel est disposé et réalisé de manière à déterminer une distance entre l'antenne directionnelle (100) et la source de brouillage (101).

8. Antenne directionnelle selon l'une quelconque des revendications précédentes,
**caractérisée en ce**
**que** l'antenne directionnelle (100) est réalisée pour la réception de signaux brouilleurs électromagnétiques (102) dans une plage de fréquences comprise entre 9 kHz et 7,5 GHz, en particulier dans une plage de fréquences comprise entre 9 kHz et 20 MHz et/ou dans une plage de fréquences comprise entre 20 MHz et 200 MHz et/ou dans une plage de fréquences comprise entre 200 MHz et 500 MHz et/ou dans une plage de fréquences comprise entre 500 MHz et 7,5 GHz.

9. Ensemble de mesure (400),
avec une antenne directionnelle (100) selon l'une quelconque des revendications précédentes,
avec un appareil de mesure réalisé sous la forme d'un analyseur de spectre (401), lequel est couplé à l'antenne directionnelle (100) et lequel est réalisé pour analyser un signal brouilleur électromagnétique (102) enregistré par l'antenne directionnelle (100).

10. Ensemble de mesure selon la revendication 9, **caractérisé en ce**
**qu'**un dispositif d'entrée (500) est prévu, par l'intermédiaire duquel des entrées spécifiques à l'utilisateur en ce qui concerne la position et/ou la nature de la source de brouillage (101) émettant le signal brouilleur électromagnétique (102) acquis peuvent être entrées.

11. Ensemble de mesure selon la revendication 10, **caractérisé en ce**
**que** le système de commande (201) est réalisé pour associer les entrées spécifiques à l'utilisateur aux informations d'image enregistrées et/ou données de relèvement acquises et pour mettre en mémoire les informations ainsi combinées les unes aux autres en tant qu'information apparentée dans une mémoire (200).

12. Ensemble de mesure selon l'une quelconque des revendications 10 à 11,
**caractérisé en ce**
**qu'**un dispositif d'affichage (403), en particulier un écran (403) ou un moniteur, est prévu, lequel est réalisé pour afficher des informations d'image enregistrées, des données de relèvement acquises, des données GPS, des informations de temps, des entrées spécifiques à l'utilisateur et/ou des données évaluées par l'analyseur de spectre (401).

13. Procédé pour la localisation d'une source de brouillage radioélectrique, comprenant les étapes suivantes :
fournir une antenne directionnelle (100) portative, qui est réalisée pour acquérir des données de relèvement d'une source de brouillage (101) émettant un signal brouilleur électromagnétique (102), et qui comprend une caméra intégrée (103) ;
déterminer la position d'une source de brouillage (101) par acquisition (S1) et évaluation d'un signal brouilleur électromagnétique (102) émis par la source de brouillage (101) et par fourniture (S2) de données de relèvement provenant d'une direction d'incidence du signal brouilleur électromagnétique (102) ;
déterminer la présence d'une condition prédéfinie, dans lequel la condition prédéfinie désigne le dépassement au moins d'une valeur de seuil en ce qui concerne le signal brouilleur électromagnétique (102) acquis ;
en fonction de la condition prédéfinie déterminée, déclencher automatiquement la caméra (103) pour l'acquisition (S3) d'une information d'image de l'environnement de la source de brouillage (101) et/ou d'un emplacement auquel le signal brouilleur électromagnétique (102) a été acquis ;
mettre en mémoire (S4) la position déterminée ainsi que l'information d'image associée.

14. Procédé selon la revendication 13, lequel comprend au moins une des autres étapes suivantes :
- déterminer une distance entre la source de brouillage (101) du signal brouilleur électromagnétique et un emplacement auquel le signal brouilleur électromagnétique (102) a été acquis ;
- caractériser le signal brouilleur électromagnétique (102) acquis et évalué ;
- adapter un foyer et/ou un objectif à focale variable de la prise de vue en fonction de la distance déterminée ;
- afficher l'information d'image enregistrée conjointement avec d'autres informations, lesquelles concernent la source de brouillage (101) ;
- déterminer des données de position GPS de l'emplacement auquel la position de la source de brouillage (101) a été déterminée ;
- déterminer des données temporelles du moment auquel la position de la source de brouillage (101) a été déterminée ;
- incruster une information concernant la direction d'incidence acquise du signal brouilleur électromagnétique (102) dans l'information d'image.
